# EUROPÄISCHE PATENTSCHRIFT

(11) **EP 3 355 075 B1**
(45) Veröffentlichungstag und Bekanntmachung des Hinweises auf die Patenterteilung: **28.08.2019**
(21) Anmeldenummer: 17205834.9
(22) Anmeldetag: 07.12.2017
(51) Int. Cl.: G01S 7/481, H01L 25/16, H01L 31/0203, G01V 8/12, G02B 6/42, H05K 3/22, G01D 11/24, H05K 1/02

(54) **SENSORANORDNUNG**
SENSOR ASSEMBLY
SYSTÈME DE DÉTECTION

(30) Priorität: 25.01.2017 DE 102017101399
(43) Veröffentlichungstag der Anmeldung: 01.08.2018
(73) Patentinhaber: SICK AG, 79183 Waldkirch (DE)
(72) Erfinder: LEITSCHUH, Daniel, 79106 Freubzrg (DE); SEEMANN, Ehrenfried, 79199 Kirchzarten (DE)

(56) Entgegenhaltungen:
- EP-A1- 2 827 368
- WO-A1-2011/129307
- DE-A1-102014 201 550
- US-A1- 2006 016 994
- US-A1- 2010 246 771
- US-A1- 2012 223 233
- US-A1- 2014 197 305
- US-A1- 2015 279 827

## Beschreibung

Die Erfindung betrifft eine Sensoranordnung, umfassend mindestens ein elektrooptisches Sendeelement und/oder mindestens ein elektrooptisches Empfangselement, welche auf einer Leiterplatte positioniert sind, wobei die Leiterplatte in einem Gehäuse angeordnet ist und eine dem Sende- und/oder dem Empfangselement gegenüberliegende Gehäuseabdeckung mindestens eine Linse aufweist.

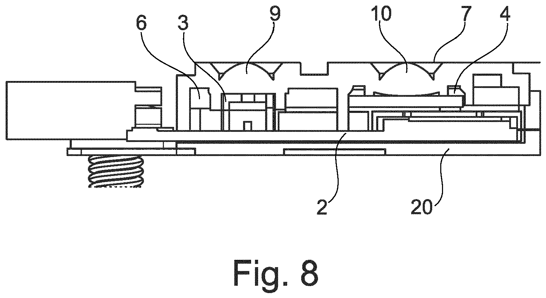

Es sind Sensoranordnungen, beispielsweise Lichtschranken-Bauformen, bekannt, die stark miniaturisierte optische Sensoren enthalten. Bei solchen Sensoranordnungen ist der zur Verfügung stehende Bauraum wesentlich für die Leistungsfähigkeit der Lichtschranken. In dem kleinsten Baugrößenbereich ist häufig die zulässige Gesamtbauhöhe auf Zehntel Millimeter genau vorgegeben. Eine solche Sensoranordnung ist in Fig. 8 dargestellt. Dabei ist eine Leiterplatte 2, auf welcher jeweils ein elektrooptisches Sendeelement 3 und/oder ein elektrooptisches Empfangselement 4 mit anderen elektronischen Bauteilen 6 angeordnet sind, in einem Gehäuse angeordnet. Das Gehäuse ist dabei allseitig geschlossen und besteht aus einer Gehäuseabdeckung 7 und einem Gehäuseboden 20. In vielen Fällen wird die Gehäuseabdeckung 7 nicht durch eine klassische Frontscheibe gebildet, sondern aus Platzgründen sind Linsen 9, 10, in die Gehäuseabdeckung 7 eingearbeitet und bilden die äußerste Schutzhülle. Der Gehäuseboden 20 wird durch ein aus Kunststoff oder Metall bestehendes Gehäuseelement gebildet. Nachteilig bei dieser Sensoranordnung ist, dass deren Leistungsfähigkeit durch die Ausbildung des Gehäuses bei gegebenen Außenabmessungen beschränkt wird.

Die EP 2 827 368 A1 offenbart ein Gehäuse für einen optischen Sensor welches ein optisch undurchlässiges Gehäuse zum Ausbilden eines Hohlraums umfasst, wenn es auf einem Substrat montiert ist, und ein optisches Element, das auf einem optisch durchlässigen Polymer basiert. Eine Öffnung in der Umhüllung ist dazu bestimmt, das optische Element an der Umhüllung zu befestigen.

Die US 20150279827 A1 offenbart ein in ein optisches Modul integriertes Gehäuse welches ein Substrat umfasst, einen lichtempfangenden Chip, der in einem lichtempfangenden Bereich des Substrats angebracht ist, eine in dem Substrat montierte elektronische Komponente, eine auf dem Substrat angebrachte Abdeckung und einen darüber angeordneten lichtempfangenden Chip und eine Linse, die fest in einem Lichtaufnahmeloch der Abdeckung angebracht ist.

Die US 20140197305 A1 offenbart eine optische Vorrichtung, die ein Substrat, eine Licht emittierende Vorrichtung, eine lichtempfindliche Vorrichtung und eine Vielzahl von Mikrolinsen umfasst. Die Licht emittierende Vorrichtung ist auf dem Substrat angeordnet und angepasst, um einen Lichtstrahl bereitzustellen. Die lichtempfindliche Vorrichtung ist auf dem Substrat angeordnet und angepasst, um einen von einem Objekt reflektierten Lichtstrahl zu empfangen, wobei die lichtempfindliche Vorrichtung eine Vielzahl von lichtempfindlichen Einheiten aufweist, die in einer Matrix angeordnet sind. Die Mikrolinsen sind oberhalb der lichtempfindlichen Vorrichtung und jeweils gegenüber den zugehörigen lichtempfindlichen Einheiten angeordnet. Es wird ferner eine lichtempfindliche Vorrichtung mit Mikrolinse und ein Herstellungsverfahren dafür bereitgestellt.

Die DE 10 2014 201 550 A1 offenbart eine Leiterplatte und ein entsprechendes Herstellungsverfahren. Die Leiterplatte weist Bauelemente und/oder Signalleitungen sowie mehrere geerdete Lagen auf. Sie ist als Mehrlagenplatine ausgeführt. Die Kanten der Leiterplatte sind metallisiert und mit mindestens einer geerdeten Lage kontaktiert.

Die US 20120223233 A1 offenbart eine Abstandserfassungsinduktionsvorrichtung umfassend ein Gehäuse, eine Kondensorlinse, eine Leiterplatte, die mehrere elektronische Komponenten trägt, eine Infrarotlicht emittierende Einrichtung zum Emittieren des Infrarotlichts und eine Lichtempfangseinrichtung zum Empfangen und Erfassen des reflektierten Infrarotlichts. Das Gehäuse umfasst einen Hauptkörper und zwei runde Öffnungen an der Oberseite des Hauptkörpers. Die Kondensorlinse hat eine Emissionslinse und eine Empfangslinse, die sich jeweils innerhalb von zwei runden Öffnungen befinden. Die Leiterplatte, die die mehreren elektronischen Komponenten trägt, wird zur Signalverarbeitung verwendet und ist innerhalb des Hauptkörpers des Gehäuses montiert.

Die US 20060016994 A1 offenbart ein Verfahren zum Montieren einer Sendevorrichtung und einer Empfangsvorrichtung auf einer Leiterplatte, wobei die Leiterplatte eine Schicht umfasst, die Lichtwellen blockiert, die von der Sendevorrichtung emittiert werden, und wobei die Sendevorrichtung und die Empfangsvorrichtung in einem Bereich angeordnet sind, der durch die Schicht definiert ist. Das Verfahren umfasst ferner das Manipulieren einer Struktur, um ein erstes Fach für die Übertragungsvorrichtung und ein zweites Fach für die Aufnahmevorrichtung zu bilden, wobei die Fächer durch eine gemeinsame Wand getrennt sind, so dass jedes Fach mit mindestens einem Teil der gemeinsamen Wand durchgehend ist. Das Verfahren umfasst ferner das Anbringen der Struktur auf der Leiterplatte. Gemäß dieser Ausführungsform können der Sender und der Empfänger Teil eines Näherungssensors sein, und die Schicht verhindert das Übersprechen zwischen dem Sender und dem Empfänger.

Gemäß der WO 2011129307 A1 wird ein Bondprozess durchgeführt, um ein Infrarotübertragungselement und eine Gehäuseabdeckung mittels eines ersten Verbindungsabschnitts, der Glas mit niedrigem Schmelzpunkt umfasst, luftdicht zu verbinden. unter Verwendung von Laserlicht, um das Glas mit niedrigem Schmelzpunkt zu erwärmen und zu schmelzen, das zwischen der Peripherie des Infrarotübertragungselements und der Peripherie eines Öffnungsabschnitts in der Gehäuseabdeckung angeordnet ist. In dem ersten Verbindungsprozess wird das Glas mit niedrigem Schmelzpunkt durch Bestrahlen mit dem Laserlicht von der Seite der Gehäuseabdeckung erwärmt und geschmolzen.

Die US 20100246771 A1 offenbart einen digitalen radiographischen Detektor mit einer Detektorplatte, die digitale Bilddaten entsprechend der Strahlungsexpositionsenergie bildet. Ein Gehäuse nimmt die Detektorplatte auf, die aus einem elektrisch leitenden Material gebildet ist und eine Basis mit einer inneren Basisoberfläche und einer äußeren Basisoberfläche aufweist und entlang ihres Umfangs eine oder mehrere Seitenwände aufweist, die sich orthogonal von der inneren Basisoberfläche erstrecken. Eine Basismagnetabschirmung erstreckt sich als eine Schicht aus nanokristallinem Material über mindestens eine von der inneren Basisoberfläche und der äußeren Basisoberfläche. Eine Abdeckung ist aus einem nicht leitenden Material gebildet und weist eine magnetische Abdeckungsabschirmung einer Schicht einer metallischen Legierung auf, die an eine innere Oberfläche gebunden ist. Eine Seitenwand-Magnetabschirmung erstreckt sich entlang einer oder mehrerer Oberflächen der einen oder mehreren Seitenwände, wobei die Seitenwand-Magnetabschirmung mindestens eines von dem nanokristallinen Material oder der Metalllegierung aufweist.

Der Erfindung liegt die Aufgabe zugrunde, eine Sensoranordnung anzugeben, bei welcher zur Verfügung stehender Bauraum in dem Gehäuse optimal genutzt wird.

Erfindungsgemäß wird die Aufgabe dadurch gelöst, dass ein die Gehäuseabdeckung tragender Gehäuseboden durch die Leiterplatte gebildet ist, wobei die Gehäuseabdeckung aus einem Kunststoff besteht, wobei die dem Gehäuseinneren zugewandten Flächen der Gehäuseabdeckung mit einer Metallisierungsschicht überzogen sind. Durch den Verzicht auf einen separaten Gehäuseboden können Anordnungen bzw. Bauelemente mit einer erhöhten Leistungsfähigkeit verwendet werden, da bei vorgegebener Gehäusehöhe größere Schnittweiten, d.h. ein größerer Abstand zwischen optoelektronischem Element und Linse eingestellt wird. Darüber hinaus vereinfacht sich der Montageprozess und der Bedarf für aufwändige Justierungsprozesse wird durch die längeren Schnittweiten reduziert. Durch die reduzierte Teileanzahl der Sensoranordnung wird darüber hinaus eine bessere Wärmeabfuhr der Elektronik nach außen gewährleistet, da die Leiterplatte selbst die äußere Begrenzung des Gehäuses bildet und die wärmeabgebenden Komponenten direkt darauf angeordnet sind.

Gemäß der Erfindung besteht die Gehäuseabdeckung aus einem Kunststoff, wobei die dem Gehäuseinneren zugewandten Flächen der Gehäuseabdeckung mit einer Metallisierungsschicht überzogen und optional geeignet mit einem Bezugspunkt, beispielsweise einem Bezugspotential, beispielsweise einem Erdungspotential der Elektronik verbunden sind. Durch diese Metallisierung wird die Schirmwirkung des Gehäuses verbessert.

Vorteilhafterweise ist die Leiterplatte mehrlagig ausgebildet, wobei eine eine Außenseite der Leiterplatte bildende Metalllage nutzsignalfrei ausgebildet ist. Durch diese nutzsignalfreie Beschaltung der äußersten Metalllage, die den Abschluss der Leiterplatte nach außen bildet, wird eine Beschädigung oder Beeinflussung der Elektronik durch eine direkte Berührung der Oberfläche des Gehäusebodens unterbunden.

In einer Ausgestaltung ist die die Außenseite der Leiterplatte bildende Metalllage als Abschirmelement ausgebildet. Da die äußerste Metalllage eine Abschirmung gegenüber Störstrahlungen bildet, wird die elektromagnetische Verträglichkeit der Sensoranordnung verbessert, ohne dass zusätzliche Schirmelemente an anderen Stellen des Gehäuses verwendet werden müssen. Dies führt zu einer Platzeinsparung im Gehäuse und zu einer Reduzierung der Teileanzahl.

In einer Variante ist die Leiterplatte um ihre Kanten herum metallisiert. Dadurch wird eine sehr gute Beständigkeit gegen chemische Einflüsse erzielt.

In einer Ausführungsform sind mindestens die Kanten der Leiterplatte mit einer Goldschicht überzogen. Diese Goldschicht trägt nicht nur zur Abwehr der äußeren chemischen Einflüsse bei, sondern bietet auch ein verbessertes Erscheinungsbild der Sensoranordnung.

In einer Weiterbildung ist die schalenförmige Gehäuseabdeckung auf die Leiterplatte aufgesetzt. Damit werden die auf der Leiterplatte befindlichen elektrischen und elektrooptischen Bauelemente zuverlässig geschützt und die Justierung der Gehäuseabdeckung zur Leiterplatte vereinfacht.

In einer Ausgestaltung sind die Außenseiten der Leiterplatte und/oder die Seitenwandungen der Gehäuseabdeckung mit einer Lackierung überzogen. Diese Lackierung bildet einen weiteren Schutz gegen äußere Einflüsse.

In einer Ausführungsform ist die Metallisierungsschicht mit der Kantenmetallisierung der Leiterplatte verbunden, wodurch sowohl der Gehäuseboden als auch die Gehäuseabdeckung umfassend gegen elektromagnetische Strahlung von außen abgeschirmt sind.

Vorteilhafterweise ist die schalenförmige Gehäuseabdeckung mit der Leiterplatte stoff- und/oder kraftschlüssig verbunden. Dies kann beispielsweise durch Verlöten oder Verkleben erfolgen. Die Verlötung kann ökonomisch beispielsweise in einem SMD Reflow-Prozess durchgeführt werden.

In einer besonders einfachen Ausführungsform besteht die Leiterplatte aus einem glasfaserverstärkten Epoxidmaterial. Aufgrund der Verwendung dieses robusten Materials kann die Leiterplatte selbst und somit die gesamte Sensoranordnung an einem vorgegebenen Gegenstand direkt angeschraubt werden.

Die Erfindung lässt zahlreiche Ausführungsformen zu. Mehrere davon sollen anhand der in der Zeichnung dargestellten Figuren näher erläutert werden. Es zeigen:
- Fig. 1: ein erstes Ausführungsbeispiel der erfindungsgemäßen Sensoranordnung,
- Fig. 2: ein weiteres Ausführungsbeispiel der erfindungsgemäßen Sensoranordnung,
- Fig. 3: ein weiteres Ausführungsbeispiel der erfindungsgemäßen Sensoranordnung,
- Fig. 4: ein weiteres Ausführungsbeispiel der erfindungsgemäßen Sensoranordnung,
- Fig. 5: ein weiteres Ausführungsbeispiel der erfindungsgemäßen Sensoranordnung,
- Fig. 6: ein weiteres Ausführungsbeispiel der erfindungsgemäßen Sensoranordnung,
- Fig. 7: ein weiteres Ausführungsbeispiel der erfindungsgemäßen Sensoranordnung,
- Fig. 8: ein Ausführungsbeispiel der Sensoranordnung gemäß dem Stand der Technik.

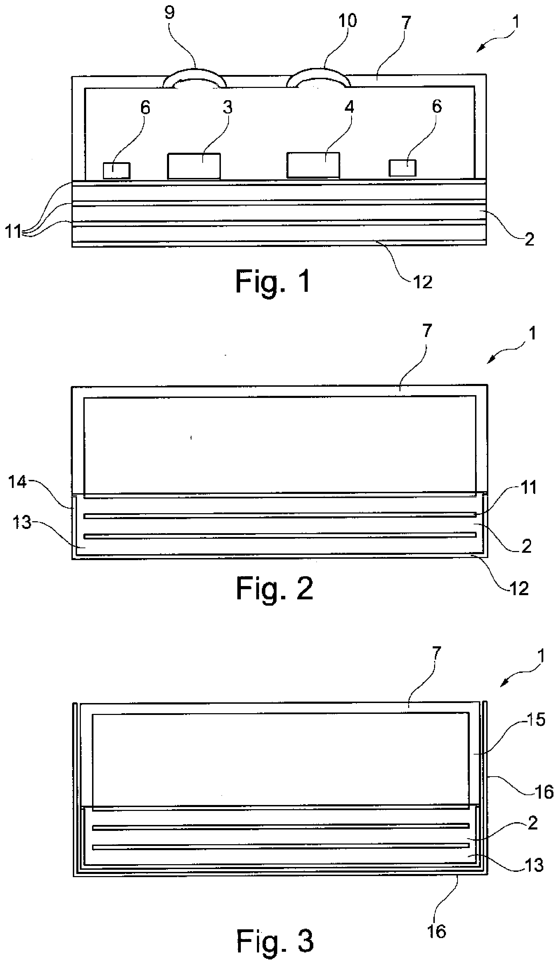

In Fig. 1 ist ein erstes Ausführungsbeispiel der erfindungsgemäßen Sensoranordnung dargestellt, welche insbesondere für Lichtschranken verwendet wird. Eine solche Sensoranordnung 1 weist dabei eine Mehrlagen-Leiterplatte 2 auf, auf welcher eine elektrooptische Sendeeinheit 3 und eine elektrooptische Empfangseinheit 4 angeordnet sind. Neben diesen beiden elektrooptischen Elementen 3 und 4 sind noch weitere elektronische Schaltungselemente 6 zur Signalaufbereitung und Signalauswertung auf der Leiterplatte 2 positioniert. Die Leiterplatte 2 ist mit einer Gehäuseabdeckung 7 versehen, die schalenförmig ausgebildet ist und direkt auf die Leiterplatte 2 aufgesetzt ist. Die Leiterplatte 2 bildet somit den Gehäuseboden. Die Gehäuseabdeckung 7 weist an ihrer der Leiterplatte 2 entgegengesetzten Frontseite 8 zwei Linsen 9, 10 auf, wobei die Linse 9 der elektrooptischen Sendeeinrichtung 3 und die Linse 10 der elektrooptischen Empfangseinrichtung 4 gegenüberliegend angeordnet ist. Die einzelnen Lagen 11 der Leiterplatte 2 sind dabei als Kupferschichten ausgebildet. Eine dieser Kupferschichten 12 bildet nach außen den Abschluss der Leiterplatte 2 und dient somit gleichzeitig als Abschirmung gegenüber äußeren Störstrahlungen. Diese äußerste Kupferlage 12 ist frei von anliegenden Nutzsignalen, so dass eine Beschädigung oder Beeinflussung der Leiterplatte 2 durch deren Berührung unterbunden wird.

In Fig. 2 ist ein weiteres Ausführungsbeispiel der Sensoranordnung 1 dargestellt, bei welchem die Kanten 13 der Leiterplatte 2 metallisiert sind. Dabei wird eine Metallisierungsschicht 14 um die Kanten 13 herumgezogen und führt bis an die Schenkel 15 der Gehäuseabdeckung 7. Diese Metallisierungsschicht 14 kann vorteilhafterweise als dünne Goldschicht ausgebildet sein und ermöglicht somit eine sehr gute Beständigkeit gegen chemische Einflüsse.

Um den Schutz gegen äußere Einflüsse weiter zu verbessern, sind, wie in Fig. 3 gezeigt, sowohl die Außenseiten der Leiterplatte 2 als auch die Schenkel 15 der schalenförmigen Gehäuseabdeckung 7 außen mit einer Schutzlackierung 16 versehen.

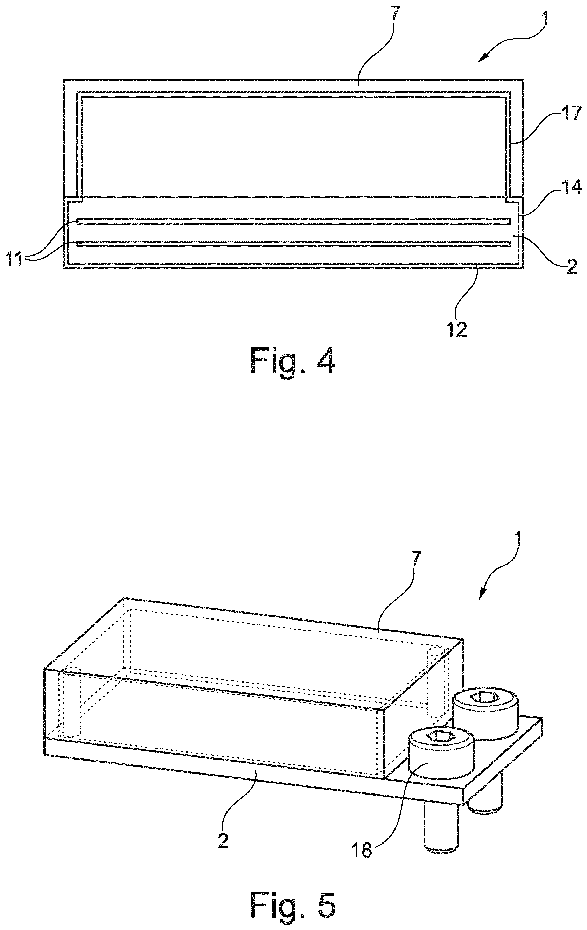

In Fig. 4 ist ein weiteres Ausführungsbeispiel der Sensoranordnung 1 dargestellt, bei welcher die Gehäuseabdeckung 7 aus einem Kunststoff besteht. In einem MID-Prozess können dabei nicht nur die Lötstellen eingebracht werden, sondern zusätzlich wird die Innenseite der Gehäuseabdeckung 7 metallisiert und damit leitfähig gemacht. Durch diese Metallschicht 17 an der Innenseite wird die Schirmwirkung der Gehäuseabdeckung 7 optimiert. Eine weitere Verbesserung der Schirmwirkung des gesamten Gehäuses wird erzielt, wenn die Metallschicht 17 der Innenseite mit der Metallisierungsschicht 14 der Kanten der Leiterplatte 2 in Verbindung steht.

Die Leiterplatte 2 besteht aus einem glasfaserverstärkten Epoxidmaterial, welche aus dem Gehäuse herausgezogen werden kann und aufgrund der robusten Eigenschaften des Epoxidmaterials die Leiterplatte 2 selbst mit Anschraubelementen 18 versehen werden kann (Fig. 5).

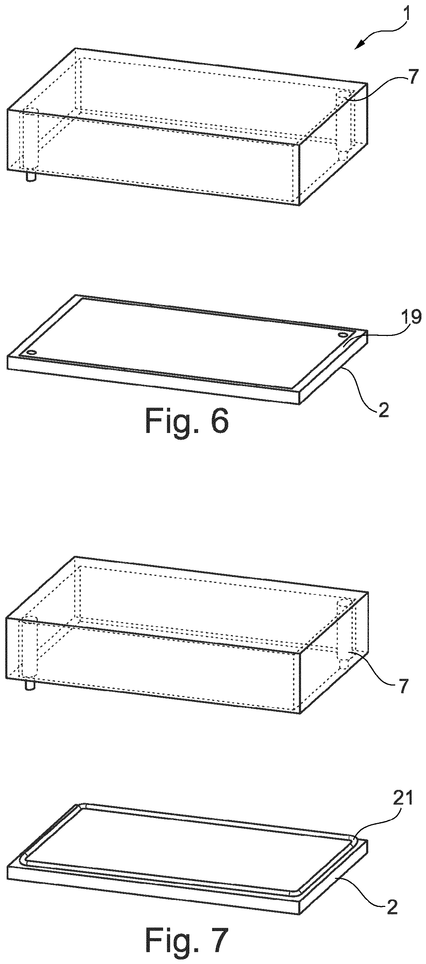

Die Gehäuseabdeckung 7 kann auf unterschiedliche Art und Weise mit der Leiterplatte 2 verbunden werden. In Fig. 6 ist ein Ausführungsbeispiel gezeigt, bei welchem die Gehäuseabdeckung 7 auf die Leiterplatte 2 aufgelötet ist. Dazu muss die Gehäuseabdeckung 7 aus einem metallischen bzw. lötfähigen Material bestehen oder die Kanten der Gehäuseabdeckung 7 müssen metallisiert werden. Die Lötschicht zwischen Leiterplatte 2 und Gehäuseabdeckung 7 ist durch den Rahmen 19 gekennzeichnet.

Als Alternative dazu ist auch ein Verkleben der schalenförmigen Gehäuseabdeckung 7 mit der Leiterplatte 2 mit einem Klebstoff 21 möglich (Fig. 7). Aber auch Verschraubungen oder andersartige mechanische Verbindungstechniken sind denkbar, um die Leiterplatte 2 mit der Gehäuseabdeckung 7 zu verbinden.

Durch die vorliegende Lösung wird die Leistungsfähigkeit bei gleicher äußerer Baugröße optimiert und unter Umständen der Montageprozess vereinfacht.

## Patentansprüche

1. Sensoranordnung, umfassend mindestens ein elektrooptisches Sendeelement (3) und/oder mindestens ein elektrooptisches Empfangselement (4), welche auf einer Leiterplatte (2) positioniert sind, wobei die Leiterplatte (2) in einem Gehäuse bestehend aus Gehäuseabdeckung (7) und Gehäuseboden angeordnet ist und die dem Sende- und/oder dem Empfangselement (3, 4) gegenüberliegende, schalenförmige Gehäuseabdeckung (7) mindestens eine Linse (9, 10) aufweist, wobei der die Gehäuseabdeckung (7) tragender Gehäuseboden durch die Leiterplatte (2) gebildet ist, wobei die Gehäuseabdeckung (7) aus einem Kunststoff besteht, wobei die dem Gehäuseinneren zugewandten Flächen der Gehäuseabdeckung (7) mit einer Metallisierungsschicht (17) überzogen sind, wobei die Leiterplatte (2) mehrlagig ausgebildet ist,
**dadurch gekennzeichnet, dass** eine die Außenseite der Leiterplatte (2) bildende Metalllage (12) nutzsignalfrei beschaltet ist, und die die Außenseite der Leiterplatte (2) bildende Metalllage (12) als Abschirmelement ausgebildet ist, wobei die Leiterplatte (2) um ihre Kanten (13) herum metallisiert ist und die Metallisierungsschicht (17) mit der Kantenmetallisierung (14) der Leiterplatte (2) verbunden ist.

2. Sensoranordnung nach Anspruch 1, **dadurch gekennzeichnet, dass** mindestens die Kanten (13) der Leiterplatte (2) mit einer Goldschicht überzogen sind.

3. Sensoranordnung nach mindestens einem der vorhergehenden Ansprüche, **dadurch gekennzeichnet, dass** die schalenförmige Gehäuseabdeckung (7) auf die Leiterplatte (2) aufgesetzt ist.

4. Sensoranordnung nach mindestens einem der vorhergehenden Ansprüche, **dadurch gekennzeichnet, dass** die Außenseiten der Leiterplatte (2) und/oder die Schenkel (15) der Gehäuseabdeckung (7) mit einer Lackierung (16) überzogen sind.

5. Sensoranordnung nach mindestens einem der vorhergehenden Ansprüche, **dadurch gekennzeichnet, dass** die schalenförmige Gehäuseabdeckung (7) mit der Leiterplatte (2) stoff- und/oder kraftschlüssig verbunden ist.

## Claims

1. A sensor arrangement, comprising at least one electro-optical transmission element (3) and/or at least one electro-optical reception element (4) that are positioned on a circuit board (2), wherein the circuit board (2) is arranged in a housing comprising a housing top (7) and a housing base and the shell-shaped housing top (7) disposed opposite the transmission and/or reception element (3, 4) has at least one lens (9, 10), wherein the housing base supporting the housing top (7) is formed by the circuit board (2), wherein the housing top (7) consists of a plastic, wherein the surfaces of the housing top (7) facing the housing interior are coated by a metalization layer (17), and wherein the circuit board (2) is multilayer,
**characterized in that**
a metal layer (12) forming the outer side of the circuit board (2) is connected free of a useful signal and the metal layer (12) forming the outer side of the circuit board (2) is formed as a screening element and the metalization layer (17) is connected to the edge metalization (14) of the circuit board (2).

2. A sensor arrangement in accordance with claim 1, **characterized in that** at least the edges (13) of the circuit board (2) are coated with a gold layer (14).

3. A sensor arrangement in accordance with one of the preceding claims, **characterized in that** the shell-shaped housing top (7) is placed onto the circuit board (2).

4. A sensor arrangement in accordance with at least one of the preceding claims, **characterized in that** the outer sides of the circuit board (2) and/or the limbs (15) of the housing top (7) are coated with a lacquer (16).

5. A sensor arrangement in accordance with at least one of the preceding claims, **characterized in that** the shell-shaped housing top (7) is connected to the circuit board (2) with material continuity and/or with a force fit.

## Revendications

1. Ensemble capteur comprenant au moins un élément d'émission électro-optique (3) et/ou au moins un élément de réception électro-optique (4), qui sont positionnés sur une carte à circuits (2), dans lequel la carte à circuits (2) est disposée dans un boîtier constitué d'un couvercle de boîtier (7) et d'un fond de boîtier, et le couvercle de boîtier (7) en forme de coque opposé à l'élément d'émission et/ou de réception (3, 4) comporte au moins une lentille (9, 10), le fond de boîtier portant le couvercle de boîtier (7) est formé par la carte à circuits (2), le couvercle de boîtier (7) est constitué en matière plastique, les surfaces du couvercle de boîtier (7) tournées vers l'intérieur du boîtier sont revêtues d'une couche de métallisation (17), la carte à circuits (2) est formée en plusieurs couches,
**caractérisé en ce que**
une couche métallique (12) formant la face extérieure de la carte à circuits (2) est connectée sans signal utile, et la couche métallique (12) formant la face extérieure de la carte à circuits (2) est réalisée comme élément de blindage, la carte à circuits (2) est métallisée autour de ses bords (13) et la couche de métallisation (17) est reliée à la métallisation de bord (14) de la carte à circuits (2).

2. Ensemble capteur selon la revendication 1, **caractérisé en ce que** au moins les bords (13) de la carte à circuits (2) sont revêtus d'une couche d'or.

3. Ensemble capteur selon l'une au moins des revendications précédentes, **caractérisé en ce que** le couvercle de boîtier (7) en forme de coque est placé sur la carte à circuits (2).

4. Ensemble capteur selon l'une au moins des revendications précédentes, **caractérisé en ce que** les faces extérieures de la carte à circuits (2) et/ou les branches (15) du couvercle de boîtier (7) sont revêtues d'un vernis (16).

5. Ensemble capteur selon l'une au moins des revendications précédentes, **caractérisé en ce que** le couvercle de boîtier (7) en forme de coque est relié par coopération de matière et/ou de force à la carte à circuits (2).
